# EUROPEAN PATENT APPLICATION

(11) **EP 1 020 922 A2**
(43) Date of publication of application: **19.07.2000**
(21) Application number: 99310309.2
(22) Date of filing: 21.12.1999
(51) Int. Cl.: H01L 29/49, H01L 21/28, H01L 21/336

(54) **Insulated gate field effect transistor and method of manufacture thereof**

(30) Priority: 28.12.1998 US 221407
(71) Applicant: Infineon Technologies North America Corp., San Jose, CA 35112 (US); International Business Machines Corporation, Armonk, NY 10504 (US)
(72) Inventor: Srinivasan, Senthil, Beacon, NY 12508-1433 (US); Weybright, Mary, Pleasant Valley, NY 12569 (US); Gambino, Jeffrey, Gaylordsville, Connecticut 06755 (US); Rupp, Thomas, Stormville, NY 12582 (US)
(74) Representative: Vigars, Christopher Ian

(57) **Abstract**

A method for forming a field effect transistor includes providing a semiconductor substrate having: a gate insulation layer; and, a gate metalization layer disposed on the gate insulation layer, such gate metalization comprising an oxidizable material. A mask is provided over the gate metalization layer, such mask having an aperture therein and masking a region of the gate metalization layer. The mask is subjected to a plasma etch to selectively remove portions of the gate metalization layer exposed by the aperture while leaving unetched the masked region of the gate metalization layer to form a gate for the transistor. An oxidation resistant layer is formed an over the formed gate. The semiconductor substrate is heated with the oxidation resistant layer. Using the gate as a mask, source and drain regions for the transistor are formed. The heating comprises heating to a temperature in the order of 1050°C to anneal the substrate. A field effect transistor includes a silicon substrate; a gate silicon dioxide layer disposed on the substrate; a gate disposed on the gate insulation layer, such gate having an oxidizable material; and an oxidation resistant layer disposed on sidewalls of the oxidizable material of the gate. The oxidizable material comprises an electrically conductive material.

## Description

### Background of the Invention

This invention relates generally to semiconductor devices and manufacturing methods and more particularly to field effect transistor semiconductor devices and manufacturing methods.

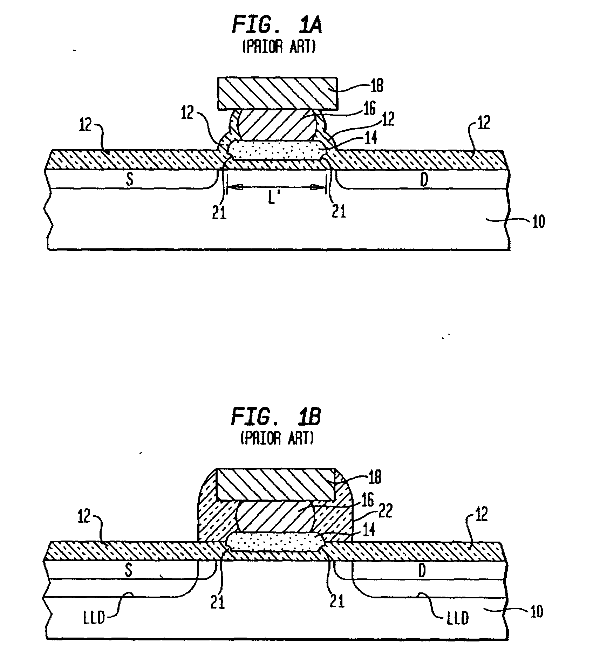

As is known in the art, semiconductor devices a\have a wide range of applications. One such device is a field effect transistor (FET) device. In a metal oxide semiconductor (MOS) FET, the gate is typically delineated by providing a mask over a gate metal stack, for example a layer of polycrystalline silicon, a layer of tungsten-silicide and a layer of silicon nitride. The gate metal stack is typically over a thin film, for example about 20 Å thick, gate silicon dioxide layer. With such mask masking the portions of the gate metal stack where the gates are to be formed, the surface of the masked structure is placed in a plasma etching chamber. The plasma etches exposed portions of the gate metal stack. The length of the masking portion of the mask is retained as the length of the resulting gate. Because of damage done by the plasma etch to the portions of the silicon substrate under the exposed portions of the mask, the structure is placed in a furnace for a rapid thermal oxidation (RTO) at high temperatures (e.g., about 1050°C) to repair the damaged silicon substrate. During the rapid thermal oxidation process a layer of silicon dioxide is grown over the thin exposed portions of the gate silicon dioxide layer and over the silicon materials in the gate stack, i.e., over the exposed sidewalls of the polycrystalline and tungsten silicide. It is also noted that during the rapid thermal oxidation process, agglomeration occurs in the tungsten silicide to condense such material as indicated in FIG. 1A where the silicon substrate is designated as 10, the layer of silicon dioxide grown during the RTO is designated as 12, the doped polycrystalline silicon, or amorphous silicon is designated as 14, the agglomerated tungsten silicide is designated as 16, and the silicon nitride is designated as 18. It is also noted that during the rapid thermal oxidation, the silicon dioxide 12 grown over the polycrystalline silicon 14 consumes surface portions of the polycrystalline silicon 14 thereby reducing the gate channel to the length L' as indicated in FIG. 1A. Further, an unwanted-bird's beak 21 is produced at the bottom edges of the polycrystalline layer 14, as indicated in FIG. 1A. After forming the gate shown in FIG. 1A, a lightly doped regions (LDD) are formed by ion implantation. After the lightly doped regions, a layer of silicon nitride 22 is deposited over the wafer and processed to provide silicon nitride spacers, as shown in FIG. 1B. After forming the silicon nitride spacers the surface of the structure is exposed to ion implantation of the source S and drain D regions, as indicated.

### Summary of the Invention

In accordance with the invention, a method for forming a field effect transistor is provided. The method includes forming a gate for the transistor, such gate comprising an oxidizable material. An oxidation resistant layer is formed over the formed gate. The gate with the oxidation resistant layer is subjecting to an oxidizing environment.

With such method, the oxidation resistant layer prevents oxidation of the oxidizable material in the gate. Further, with such method, the gate is encapsulated in an oxidation resistant material prior to the rapid thermal oxidation step used to heal the substrate. This maintains the mask delineated gate length, L, and prevents birds-beak formation.

In one embodiment, the gate is used as a mask in forming the source and drain regions for the transistor.

In accordance with another embodiment, a method for forming a field effect transistor is provided. The method includes providing a semiconductor substrate having: a gate insulation layer; and, a gate metalization layer disposed on the gate insulation layer, such gate metalization comprising an oxidizable material. A mask is provided over the gate metallzation layer, such mask having an aperture therein and masking a region of the gate metalization layer. The mask is subjected to a plasma etch to selectively remove portions of the gate metalization layer exposed by the aperture while leaving unetched the masked region of the gate metalization layer to form a gate for the transistor. An oxidation resistant layer is formed over the formed gate. The semiconductor substrate is heated with the oxidation resistant layer. Using the gate as a mask, source and drain regions for the transistor are formed.

In accordance with another embodiment, the heating comprises heating to a temperature in the order of 1050°C.

In accordance with another embodiment, the heating comprises annealing such substrate.

In accordance with another embodiment, a method is provided for forming a field effect transistor. The method includes providing a semiconductor substrate having: a gate insulation layer; and, a gate metalization layer disposed on the gate insulation layer. The gate metalization comprising an oxidizable material. A mask is provided over the gate metalization layer. The mask has an aperture therein and masks a region of the gate metalization layer. The mask is subjected to a plasma etch to selectively remove portions of the gate metalization layer exposed by the aperture while leaving unetched the masked region of the gate metalization layer to form a gate for the transistor. An oxidation resistant layer is formed an over the formed gate. The semiconductor substrate with the insulation layer and oxidation resistant layer are subjecting to an oxidizing environment. Using the gate as a mask, the source and drain regions for the transistor are formed.

In accordance with another embodiment, a field effect transistor is provided. The transistor includes a silicon substrate; a gate silicon dioxide layer disposed on the substrate; a gate disposed on the gate insulation layer, such gate having an oxidizable material; and an oxidation resistant layer disposed on sidewalls of the oxidizable material of the gate.

In one embodiment, the oxidizable material comprises an electrically conductive material.

In one embodiment, the oxidizable material comprises silicon.

In one embodiment, the oxidizable material comprises a layer of doped silicon and a layer of silicide on the layer of doped silicon.

### Brief Description of the Drawing

These and other features of the invention, as well as the invention itself, will become more readily apparent from the following detailed description when read together with the accompanying drawings, in which:
FIGS. 1A and 1B are diagrammatical cross-sectional sketches of a field effect transistor at various stages in the fabrication thereof according to the PRIOR ART;
FIGS. 2A-2F are diagrammatical cross-sectional sketches of a field effect transistor at various stages in the fabrication thereof according to the invention.

### Description of the Preferred Embodiments

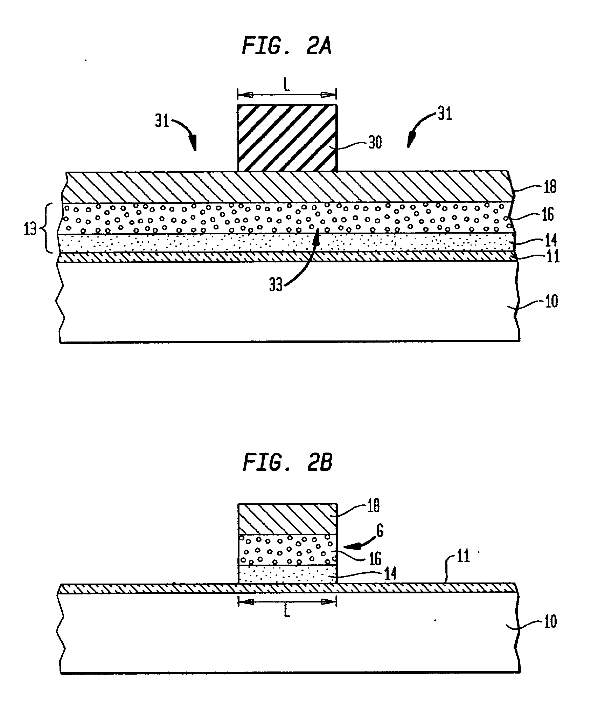

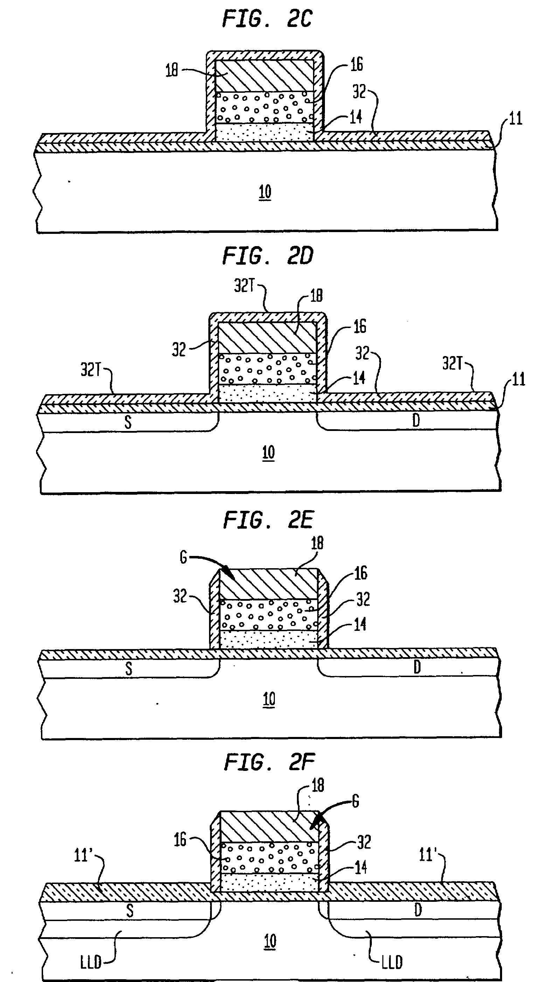

Referring now to FIG. 2A, a semiconductor, here silicon, substrate 10 is provided having: a gate insulation layer 11, here a thermally grown silicon dioxide layer about 20 Å thick; and, a gate metalization layer 13 disposed on the gate insulation layer 11. Here, the gate metalization layer 13 comprises: a layer 14 of doped silicon and a layer 16 of silicide on the layer of doped silicon 14. More particularly, here the gate metalization layer 13 comprises a lower layer 14 of doped polycrystalline silicon, or amorphous silicon. In this example, the silicide layer 16 is here tungsten silicide disposed on the doped polycrystalline layer 14 and the layer 18 is a silicon nitride hard mask disposed on the tungsten silicide layer 16. (It should be noted that layer 18 is optional and is not part of the metalization layer. Layer 18 may be TEOS or can be omitted). Thus, the layers 14 and 16 provide a gate metalization layer or stack 13. It should be noted that the gate metalization stack 13 may be another electrically conductive material, such as copper, aluminum, or tungsten, or combinations of such materials.

Next, a mask 30 is formed over the gate metalization layer 13 and hard mask 18. The mask 30 has an aperture 31 therein. The mask 30 masks a region 33 of the gate metalization layer 13 and layer 18 where the gate of the field effect transistor will be formed. The mask 30 is subjected to a plasma etch to selectively remove portions of the gate metalization layer 13 and layer 18 exposed by the aperture 31 while leaving unetched the masked region of the gate metalization layer 13 and layer 18 to form the gate G for the transistor (FIG. 2B). The mask 30 is then removed to produce the structure shown in FIG. 2B.

Next, referring to FIG. 2C, an oxidation resistant layer 32 is formed over the formed gate G and over portions of the gate silicon dioxide layer 11 exposed by the removed portions of the gate metalization layer 13 (FIG. 2B). Here, the oxidation resistant layer 32 is a layer of silicon nitride deposited by chemical vapor deposition as a conformal deposition having a thickness of less than 15 nanometers. Alternatively, the oxidation resistant layer 32 may be silicon oxynitride (SiONₓ). After removing any portions of the oxidation resistant layer 32 on the backside of the wafer, not shown, the front surface of the wafer is subjected to ion implantation to form the lightly doped regions, as shown in FIG. 2C. It is noted that the oxidation resistant layer 32 acts as a scattering medium and an impurity filter during the ion implantation process.

Next, a plasma etch (i.e., a reactive ion etch, RIE) is used to remove exposed surface portions 32T of the oxidation resistant layer 32 thereby producing the structure shown in FIG. 2E. Thus, the RIE selectively removes portions 32T of the oxidation resistant layer 32 from top portions of the gate G and over portions of the gate silicon dioxide layer 11 exposed by the removed portions of the gate metalization layer 13 (FIG. 2A) while retaining portions of the oxidation resistant layer 32 from sidewalls of the gate G.

Next, the structure shown in FIG. 2E is subjected to a rapid thermal oxidation (RTO). Here, the RTO is at a temperature in the order of 1050°C. The RTO anneals the silicon substrate 10 with the gate silicon dioxide layer 11. The oxidation increases the silicon dioxide layer 11 to the thickness shown in FIG. 2F for layer 11'. The oxidation resistant layer 32 over the sidewalls of the gate G inhibits oxidation of the polycrystalline silicon layer 14 and prevents oxidation, and agglomeration of, the tungsten silicide layer 16 during such annealing.

Next, using the gate G with the oxidation resistant layer 32 on the sidewalls thereof as a mask, the source and drain regions S, D for the transistor are formed.

Other embodiments are within the spirit and scope of the appended claims.

## Claims

1. A method for forming a field effect transistor, comprising:
forming a gate for the transistor, such gate comprising an oxidizable material; forming an oxidation resistant layer over the formed gate; subjecting the gate with the oxidation resistant layer to an oxidizing environment; and forming source and drain regions for the transistor.

2. The method recited in claim 1 wherein the source and drain region formation comprises using the gate as a mask in forming the source and drain regions for the transistor.

3. A method for forming a field effect transistor, comprising:
providing a semiconductor substrate having: a gate insulation layer; and, a gate metalization layer disposed on the gate insulation layer, such gate metalization comprising an oxidizable material; providing a mask over the gate metalization layer, such mask having an aperture therein, such mask masking a region of the gate metalization layer; subjecting the mask to a plasma etch to selectively remove portions of the gate metalization layer exposed by the aperture while leaving unetched the masked region of the gate metalization layer to form a gate for the transistor; forming an oxidation resistant layer over the formed gate; heating the semiconductor substrate with the oxidation resistant layer; and forming source and drain regions for the transistor.

4. The method recited in claim 3 wherein the source and drain region formation comprises using the gate as a mask in forming the source and drain regions for the transistor.

5. The method recited in claim 4 wherein the heating comprises heating to a temperature in the order of 1050°C.

6. The method recited in claim 4 wherein the heating comprises annealing such substrate.

7. A method for forming a field effect transistor, comprising:
providing a semiconductor substrate having: a gate insulation layer; and, a gate metalization layer disposed on the gate insulation layer, such gate metalization comprising an oxidizable material; providing a mask over the gate metalization layer, such mask having an aperture therein, such mask masking a region of the gate metalization layer; subjecting the mask to a plasma etch to selectively remove portions of the gate metalization layer exposed by the aperture while leaving unetched the masked region of the gate metalization layer to form a gate for the transistor; forming an oxidation resistant layer over the formed gate; subjecting the semiconductor substrate with the insulation layer and oxidation resistant layer to an oxidizing environment; and forming source and drain regions for the transistor.

8. The method recited in claim 7 wherein the source and drain region formation comprises using the gate as a mask in forming the source and drain regions for the transistor.

9. A method for forming a field effect transistor, comprising:
providing a semiconductor substrate having: a gate insulation layer; and, a gate metalization layer disposed on the gate insulation layer, such gate metalization comprising an oxidizable material; providing a mask over the gate metalization layer, such mask having an aperture therein, such mask masking a region of the gate metalization layer; subjecting the mask to a plasma etch to selectively remove portions of the gate metalization layer exposed by the aperture while leaving unetched the masked region of the gate metalization layer to form a gate for the transistor; forming an oxidation resistant layer over the formed gate and over portions of the insulating layer exposed by the removed portions of the gate metalization layer; selectively removing portions of the oxidation resistant layer from top portions of the gate and over portions of the insulating layer exposed by the removed portions of the gate metalization layer while retaining portions of the oxidation resistant layer from sidewalls of the gate; subjecting the semiconductor substrate with the insulation layer and oxidation resistant layer over the sidewalls of the gate to an oxidizing environment; and forming source and drain regions for the transistor.

10. The method recited in claim 9 wherein the source and drain formation comprises using the gate with the oxidation resistant layer on the sidewalls thereof as a mask in forming the source and drain regions for the transistor.

11. A method for forming a field effect transistor, comprising:
providing a silicon substrate having: a gate silicon dioxide layer; and, a gate metalization layer disposed on the gate insulation layer, such gate metalization comprising: a layer of doped silicon and a layer of silicide on the layer of doped silicon; providing a mask over the gate metalization layer, such mask having an aperture therein, such mask masking a region of the gate metalization layer; subjecting the mask to a plasma etch to selectively remove portions of the gate metalization layer exposed by the aperture while leaving unetched the masked region of the gate metalization layer to form a gate for the transistor; forming an oxidation resistant layer over the formed gate and over portions of the gate silicon dioxide layer exposed by the removed portions of the gate metalization layer; selectively removing portions of the oxidation resistant layer from top portions of the gate and over portions of the gate silicon dioxide layer exposed by the removed portions of the gate metalization layer while retaining portions of the oxidation resistant layer from sidewalls of the gate; heating the silicon substrate with the gate silicon dioxide layer and oxidation resistant layer over the sidewalls of the gate to a temperature in the order of 1050°C to an oxidizing environment, such oxidation resistant layer inhibiting oxidation of the doped silicon and silicide materials of the gate during such heating; and forming source and drain regions for the transistor.

12. The method recited in claim 11 wherein the heating comprises heating to a temperature in the order of 1050°C.

13. The method recited in claim 12 wherein the heating comprises annealing such substrate.

14. A method for forming a field effect transistor, comprising:
providing a silicon substrate having: a gate silicon dioxide layer; and, a gate metalization layer disposed on the gate insulation layer, such gate metalization comprising: a layer of doped silicon and a layer of silicide on the layer of doped silicon; providing a mask over the gate metalization layer, such mask having an aperture therein, such mask masking a region of the gate metalization layer; subjecting the mask to a plasma etch to selectively remove portions of the gate metalization layer exposed by the aperture while leaving unetched the masked region of the gate metalization layer to form a gate for the transistor;forming an oxidation resistant layer over the formed gate and over portions of the gate silicon dioxide layer exposed by the removed portions of the gate metalization layer; selectively removing portions of the oxidation resistant layer from top portions of the gate and over portions of the gate silicon dioxide layer exposed by the removed portions of the gate metalization layer while retaining portions of the oxidation resistant layer from sidewalls of the gate; annealing the silicon substrate with the gate silicon dioxide layer and oxidation resistant layer over the sidewalls of the gate, such oxidation resistant layer inhibiting oxidation of the doped silicon and silicide materials of the gate during such annealing; and forming source and drain regions for the transistor.

15. The method recited in claim 14 wherein the annealing includes heating the substrate to a temperature in the order of 1050°C.

16. A field effect transistor, comprising:
a silicon substrate;
a gate silicon dioxide layer disposed on the substrate;
a gate disposed on the gate insulation layer, such gate having an oxidizable material; and
an oxidation resistant layer disposed on sidewalls of the oxidizable material of the gate.

17. The field effect transistor recited in claim 16 wherein the oxidizable material comprises an electrically conductive material.

18. The field effect transistor recited in claim 17 wherein the oxidizable material comprises silicon.

19. The field effect transistor recited in claim 18 wherein the oxidizable material comprises a layer of doped silicon and a layer of silicide on the layer of doped silicon.

20. The transistor recited in claim 19 wherein the gate comprises aluminum, copper, tungsten, or a combination thereof or a combination of similar electrically conductive material.
